(19) Europäisches Patentamt / European Patent Office / Office européen des brevets

(11) **EP 2 494 665 B1**

(12) **EUROPÄISCHE PATENTSCHRIFT**

(45) Veröffentlichungstag und Bekanntmachung des Hinweises auf die Patenterteilung:
**17.12.2014 Patentblatt 2014/51**

(21) Anmeldenummer: **10747205.2**

(22) Anmeldetag: **25.08.2010**

(51) Int Cl.:
*H01S 5/10* (2006.01)  *H01S 5/20* (2006.01)
*H01S 5/042* (2006.01)  *H01S 5/32* (2006.01)
*H01S 5/40* (2006.01)

(86) Internationale Anmeldenummer:
**PCT/EP2010/062416**

(87) Internationale Veröffentlichungsnummer:
**WO 2011/051013 (05.05.2011 Gazette 2011/18)**

(54) **KANTENEMITTIERENDER HALBLEITERLASER**

EDGE EMITTING SEMICONDUCTOR LASER

LASER À SEMI-CONDUCTEURS À ÉMISSION LATÉRALE

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **30.10.2009 DE 102009051348**
**30.11.2009 DE 102009056387**

(43) Veröffentlichungstag der Anmeldung:
**05.09.2012 Patentblatt 2012/36**

(73) Patentinhaber: **OSRAM Opto Semiconductors GmbH**
**93055 Regensburg (DE)**

(72) Erfinder:
• **LAUER, Christian**
**93053 Regensburg (DE)**
• **GOMEZ-IGLESIAS, Alvaro**
**93047 Regensburg (DE)**

(74) Vertreter: **Epping - Hermann - Fischer Patentanwaltsgesellschaft mbH**
**Schloßschmidstraße 5**
**80639 München (DE)**

(56) Entgegenhaltungen:
WO-A1-2009/143813    DE-A1-102008 013 896
US-A1- 2009 213 887

• SELMIC S R ET AL: "Single Frequency 1550-nm AlGaInAs-InPTapered High-Power Laser With a Distributed Bragg Reflector" IEEE PHOTONICS TECHNOLOGY LETTERS, IEEE SERVICE CENTER, PISCATAWAY, NJ, US, Bd. 14, Nr. 7, 1. Juli 2002 (2002-07-01), XP011067205 ISSN: 1041-1135
• ECKSTEIN H-C ET AL: "Control of slow axis mode behavior with waveguide phase structures in semiconductor broad-area lasers" PROCEEDINGS OF THE INTERNATIONAL SOCIETY FOR OPTICAL ENGINEERING (SPIE), SPIE, USA LNKD- DOI:10.1117/12.819399, Bd. 7230, 3. Februar 2009 (2009-02-03), Seiten 72301L/1-7, XP009123054 ISSN: 0277-786X
• YOSHIAKI WATANABE ET AL: "Laterally Coupled Strained MQW Ridge Waveguide Distributed-Feedback Laser Diode Fabricated by Wet-Dry Hybrid Etching Process" IEEE PHOTONICS TECHNOLOGY LETTERS, IEEE SERVICE CENTER, PISCATAWAY, NJ, US, Bd. 10, Nr. 12, 1. Dezember 1998 (1998-12-01), XP011046391 ISSN: 1041-1135
• SRINIVASAN S T ET AL: "Semiconductor laser with unstable resonator consisting of negative cylindrical lenses" PROCEEDINGS OF THE SPIE - THE INTERNATIONAL SOCIETY FOR OPTICAL ENGINEERING USA, Bd. 1634, 1992, Seiten 413-419, XP002606918 ISSN: 0277-786X

EP 2 494 665 B1

• PAUL O LEISHER ET AL: "Stabilization of Lateral Mode Transients in High-Power Broad Area Semiconductor Lasers" LASERS AND ELECTRO-OPTICS SOCIETY, 2007. LEOS 2007. THE 20TH ANNUAL ME ETING OF THE IEEE, IEEE, PI, 1. Oktober 2007 (2007-10-01), Seiten 307-308, XP031160574 ISBN: 978-1-4244-0924-2

## Beschreibung

Die Erfindung betrifft einen kantenemittierenden Halbleiterlaser mit einem Phasenstrukturbereich zur Selektion lateraler Lasermoden.

Diese Patentanmeldung beansprucht die Priorität der deutschen Patentanmeldungen 10 2009 051 348.5 und 10 2009 056 387.3

Kantenemittierende Halbleiterlaser für hohe Ausgangsleistungen werden meist als Breitstreifenlaser ausgeführt, bei denen der aktive Bereich eine Breite von beispielsweise 100 μm oder mehr aufweisen kann. Wegen der vergleichsweise großen lateralen Ausdehnung des aktiven Bereichs können bei derartigen Halbleiterlasern in der Regel viele laterale Lasermoden anschwingen. Ein Multimode-Betrieb eines kantenemittierenden Halbleiterlasers erschwert insbesondere die Einkopplung des emittierten Laserlichts in nachfolgende optische Elemente, beispielsweise in Lichtleiter.

Zur Unterdrückung höherer lateraler Lasermoden, insbesondere zum Erzielen eines Betriebs in der lateralen Grundmode, ist aus der Druckschrift WO 01/97349 A1 bekannt, Phasenstrukturen in dem Wellenleiter eines kantenemittierenden Halbleiterlasers auszubilden. Bei den Phasenstrukturen handelt es sich um Bereiche des Halbleiterkörpers, in denen der effektive Brechungsindex von dem effektiven Brechungsindex der in lateraler Richtung angrenzenden Bereiche des Halbleiterkörpers abweicht und die so ausgebildet sind, dass höhere Lasermoden größere Umlaufverluste in dem Laserresonator erleiden als die laterale Grundmode des Halbleiterlasers. Die Phasenstrukturen können in dem kantenemittierenden Halbleiterlaser beispielsweise dadurch erzeugt werden, dass von der Oberfläche des Halbleiterkörpers her Strukturen in den Halbleiterkörper geätzt werden, die sich bis in die zweite Mantelschicht oder sogar bis in den Wellenleiterbereich hinein erstrecken. Die Strukturen können beispielsweise durch Simulationen derart optimiert werden, dass sie für die laterale Grundmode geringere Verluste erzeugen als für die höheren Lasermoden, so dass das Anschwingen des Lasers in der lateralen Grundmode begünstigt wird.

Die für im sichtbaren Spektralbereich emittierende Halbleiterlaser an sich bekannten Phasenstrukturen lassen sich nicht ohne weiteres auf im infraroten Spektralbereich emittierende Halbleiterlaser übertragen. Dies beruht darauf, dass die Laserstrahlung bei Halbleiterlasern im infraroten Spektralbereich stärker auf den Wellenleiterbereich konzentriert ist und weniger stark in die Mantelschichten eindringt als bei Halbleiterlasern im sichtbaren Spektralbereich. Zudem sind die Mantelschichten bei Halbleiterlasern im infraroten Spektralbereich aufgrund der vergleichsweise großen Wellenlänge verhältnismäßig dick. Aus diesem Grund ist die Wirkung von Phasenstrukturen mit geringen Ätztiefen in der zweiten Mantelschicht nur sehr gering. Andererseits zeigt sich eine starke Abhängigkeit der Wirkung von Phasenstrukturen von der Ätztiefe, wenn bis in die Nähe des Wellenleiterbereichs geätzt wird. Zur Realisierung von Phasenstrukturen für Halbleiterlaser im infraroten Spektralbereich wäre es also erforderlich, vergleichsweise tiefe Ätzstrukturen in dem Halbleiterkörper zu erzeugen, deren Tiefe sehr genau definiert sind. Beide Anforderungen lassen sich aber nur schwer gleichzeitig erfüllen.

Die Druckschrift H.-C. Eckstein et al.: "Control of slow axis mode behavior with waveguide phase structures in semiconductor broad-area lasers", Proceedings of the International Society for Optical Engeneering (SPIE), Bd. 7320 (2009), S. 7230L1-7, beschreibt einen Halbleiterlaser mit Phasenstrukturen, die sich bis in die obere Mantelschicht des Halbleiterlasers erstrecken.

Die Druckschrift S. R. Selmic et al.: "Single Frequency 1550-nm AlGaInAs-InP Tapered High-Power Laser With a Distributed Bragg Reflector", IEEE Photonics Technology Letters, Bd. 14, Nr. 7 (2002), S. 890-892, beschreibt einen Halbleiterlaser mit Ätzstrukturen, die sich bis in die obere Mantelschicht erstrecken, wobei zur Definition der Tiefe der Ätzstrukturen eine Ätzstoppschicht in der Mantelschicht enthalten ist.

Eine Aufgabe besteht darin, einen kantenemittierenden Halbleiterlaser anzugeben, der eine Halbleiterschichtenfolge aufweist, welche die Herstellung von Phasenstrukturen mit variierender Tiefe vereinfacht, wobei die Phasenstrukturen insbesondere auch für Halbleiterlaser im infraroten Spektralbereich zu realisieren sind.

Diese Aufgabe wird durch einen kantenemittierenden Halbleiterlaser mit den Merkmalen des unabhängigen Anspruchs 1 gelöst. Vorteilhafte Ausgestaltungen und Weiterbildungen der Erfindung sind Gegenstand der abhängigen Ansprüche.

Gemäß zumindest einer Ausführungsform der Erfindung enthält ein kantenemittierender Halbleiterlaser einen Halbleiterkörper mit einem Wellenleiterbereich, wobei der Wellenleiterbereich eine erste Wellenleiterschicht, eine zweite Wellenleiterschicht und eine zwischen der ersten Wellenleiterschicht und der zweiten Wellenleiterschicht angeordnete aktive Schicht zur Erzeugung von Laserstrahlung aufweist. In der aktiven Schicht des Halbleiterkörpers wird im Betrieb des Halbleiterlasers elektromagnetische Strahlung erzeugt und verstärkt. Beispielsweise beinhaltet die aktive Schicht einen oder mehrere Quantentöpfe, Quantendrähte oder Quantenpunkte.

Der Wellenleiterbereich ist zwischen einer ersten Mantelschicht und einer dem Wellenleiterbereich in Wachstumsrichtung des Halbleiterkörpers nachfolgenden zweiten Mantelschicht angeordnet. Die erste und zweite Mantelschicht weisen vorteilhaft einen geringeren Brechungsindex als die Wellenleiterschichten auf. Aufgrund des Brechungsindexunterschieds zwischen dem Wellenleiterbereich und den Mantelschichten ist das Modenprofil stark auf den Wellenleiterbereich konzentriert. Dennoch dringen die Lasermoden zumindest geringfügig in die Mantelschichten ein.

In dem Halbleiterkörper ist vorteilhaft eine Phasenstruktur zur Selektion lateraler Moden der von der aktiven Schicht emittierten Laserstrahlung ausgebildet, wobei die Phasenstruktur mindestens eine Ausnehmung umfasst, die sich von einer Oberfläche des Halbleiterkörpers in die zweite Mantelschicht hinein erstreckt. Die Phasenstruktur ist vorzugsweise derart ausgebildet, dass die laterale Grundmode der Laserstrahlung geringere Verluste als die Strahlung höherer Lasermoden erfährt. Aufgrund der Phasenstruktur erfährt die Laserstrahlung, die sich in dem Wellenleiterbereich ausbreitet, Umlaufverluste, wobei der strukturierte Bereich derart ausgebildet ist, dass höhere Lasermoden stärker gedämpft werden als die laterale Grundmode. Auf diese Weise kann insbesondere erreicht werden, dass beim Betrieb des Halbleiterlasers nur eine oder wenige bevorzugte Lasermoden, vorzugsweise nur die laterale Grundmode, anschwingen.

Dadurch, dass höhere Moden der Laserstrahlung unterdrückt werden und vorzugsweise nur die laterale Grundmode anschwingt, wird eine hohe Strahlqualität des kantenemittierenden Halbleiterlasers erzielt. Insbesondere eignet sich das Strahlprofil der lateralen Grundmode gut für eine Strahlformung mit optischen Elementen und insbesondere für die hocheffiziente Einkopplung in eine Lichtleitfaser.

In die zweite Mantelschicht ist mindestens eine Zwischenschicht aus einem von dem Halbleitermaterial der zweiten Mantelschicht verschiedenen Halbleitermaterial eingebettet. Die mindestens eine Ausnehmung, welche die Phasenstruktur ausbildet, erstreckt sich von der Oberseite des Halbleiterkörpers zumindest teilweise bis in die Zwischenschicht.

Das Erzeugen der Phasenstruktur durch Ausbildung von einer oder mehreren Ausnehmungen in dem Halbleiterkörper kann insbesondere mit einem Ätzprozess erfolgen, bei dem die zweite Mantelschicht teilweise abgetragen wird. Bei dem Ätzprozess kann es sich um einen nasschemischen Ätzprozess oder um einen Trockenätzprozess handeln. Die in die zweite Mantelschicht eingebettete Zwischenschicht fungiert vorteilhaft als Indikatorschicht für das Erreichen einer gewünschten Ätztiefe und erleichtert auf diese Weise die gezielte und reproduzierbare Herstellung von Ausnehmungen mit definierter Tiefe. Die in die zweite Mantelschicht eingebettete Zwischenschicht kann bei nasschemischer Ätzung des Halbleiterkörpers, insbesondere der zweiten Mantelschicht, als Ätzstoppschicht verwendet werden. In diesem Fall wird für die Zwischenschicht ein Halbleitermaterial verwendet, das für die verwendete Ätzlösung eine geringere Ätzrate als die zweite Mantelschicht aufweist.

Wenn ein Trockenätzprozess wie beispielsweise eine Plasmaätzung zur Herstellung der einen oder mehreren Ausnehmungen in dem Halbleiterkörper verwendet wird, kann mittels Überwachung der optischen Emission des Plasmas in der Prozesskammer während des Ätzprozesses auf das Erreichen der Zwischenschicht geschlossen und an dieser Stelle der Ätzprozess gestoppt werden. Um eine besonders homogene und definierte Ätztiefe zu erzielen, ist es in diesem Fall vorteilhaft, wenn die Zwischenschicht bei dem Plasmaätzprozess eine geringere Ätzrate als die zweite Mantelschicht aufweist.

Bei einer bevorzugten Ausführungsform ist das Halbleitermaterial der Zwischenschicht ein III-V-Halbleitermaterial, das mindestens ein Element der dritten oder fünften Hauptgruppe des Periodensystems enthält, das in der zweiten Mantelschicht nicht enthalten ist. Die zweite Mantelschicht enthält vorzugsweise ein III-V-Halbleitermaterial wie insbesondere $Al_xGa_{1-x}As$ mit $0 \leq x \leq 1$, bevorzugt mit $0 < x < 1$. Das Halbleitermaterial der zweiten Mantelschicht enthält vorzugsweise außer Al, Ga und As keine weiteren Hauptbestandteile, abgesehen von einem oder mehreren Dotierstoffen oder eventuellen Verunreinigungen. Die Zwischenschicht enthält vorzugsweise ein Halbleitermaterial, welches In und/oder P enthält.

Das Halbleitermaterial der mindestens einen Zwischenschicht wird bevorzugt derart gewählt, dass es gitterangepasst an die umgebenden Halbleiterschichten ist. Weiterhin ist es vorteilhaft, wenn die für den Leitungstyp der Zwischenschicht relevante Bandkante, das heißt auf der p-Seite der aktiven Zone das Valenzband und auf der n-Seite das Leitungsband, im Wesentlichen mit der umgebenden zweiten Mantelschicht übereinstimmt.

Gemäß einer bevorzugten Ausführungsform weist die Zwischenschicht eine Dicke zwischen einschließlich 10 nm und einschließlich 100 nm auf. Besonders bevorzugt beträgt die Dicke der Zwischenschicht zwischen einschließlich 20 nm und einschließlich 50 nm. Bei einer derart geringen Dicke hat die Zwischenschicht nur einen geringen Einfluss auf die sich im Halbleiterkörper ausbreitenden Lasermoden. Für die Zwischenschicht kann daher vorteilhaft auch ein Halbleitermaterial verwendet werden, dessen Brechzahl nicht notwendigerweise an die Brechzahl der umgebenden zweiten Mantelschicht angepasst sein muss.

In die zweite Mantelschicht ist mindestens eine weitere Zwischenschicht eingebettet, wobei sich die Ausnehmung zumindest teilweise bis in die zweite Zwischenschicht hinein erstreckt. Die zweite Zwischenschicht ist von der Oberfläche des Halbleiterkörpers aus gesehen in einer anderen Tiefe angeordnet als die erste Zwischenschicht. Die zweite Zwischenschicht fungiert vorteilhaft als Indikatorschicht für das Erreichen einer zweiten Ätztiefe, die von einer ersten Ätztiefe verschieden ist, für die die erste Zwischenschicht als Indikatorschicht fungiert. Die zweite Mantelschicht ist also vorzugsweise an mindestens einem Punkt bis in die erste Zwischenschicht abgetragen und an mindestens einem weiteren Punkt bis in die zweite Zwischenschicht abgetragen.

Die Ausnehmung erstreckt sich an mindestens einem ersten Punkt bis in die erste Zwischenschicht und an mindestens einem zweiten Punkt bis in die zweite Zwischenschicht. Dabei weist die Ausnehmung zwischen dem ersten Punkt und dem zweiten Punkt eine räumlich variierende Tiefe auf. Die Tiefe der mindestens einen Ausnehmung und somit die Dicke der zweiten Mantelschicht kann beispielsweise zwischen dem ersten Punkt und dem zweiten Punkt kontinuierlich, vorzugsweise linear, zunehmen oder abnehmen. Alternativ kann die Tiefe der Ausnehmung auch stufenförmig in mehreren Stufen zunehmen oder abnehmen. Durch die räumlich variierende Tiefe der Ausnehmung werden abrupte Änderungen des Brechungsindex zwischen der Phasenstruktur und dem Hauptbereich des Halbleiterkörpers verringert. Auf diese Weise werden Koppelverluste, die beim Übertritt der Laserstrahlung von dem Hauptbereich in den Phasenstrukturbereich des Halbleiterkörpers auftreten können, verringert, wodurch sich vorteilhaft die Effizienz des Halbleiterlasers verbessert.

Bei einer weiteren vorteilhaften Ausgestaltung weist die zweite Mantelschicht eine erste Teilschicht, die an den Wellenleiterbereich angrenzt, und eine zweite Teilschicht, die an die erste Teilschicht angrenzt, auf, wobei die erste Teilschicht einen größeren Brechungsindex als die zweite Teilschicht aufweist. Dabei wird die mindestens eine Zwischenschicht, die in die zweite Mantelschicht eingebettet ist, nicht als erste oder zweite Teilschicht der Mantelschicht betrachtet. Im Fall einer aus zwei Teilschichten zusammengesetzten zweiten Mantelschicht ist die mindestens eine Zwischenschicht also in die erste oder in die zweite Teilschicht eingebettet.

Bevorzugt ist die mindestens eine Zwischenschicht in die erste Teilschicht der zweiten Mantelschicht eingebettet. Die erste Teilschicht der zweiten Mantelschicht weist einen Brechungsindex auf, der zwischen den Brechungsindices der zweiten Wellenleiterschicht und der zweiten Teilschicht der zweiten Mantelschicht liegt. Der Brechungsindex nimmt also abgesehen von der mindestens einen eingebetteten Zwischenschicht von der zweiten Wellenleiterschicht zur nachfolgenden ersten Teilschicht der zweiten Mantelschicht und zur zweiten Teilschicht der zweiten Mantelschicht stufenförmig ab. Auf diese Weise kann erreicht werden, dass der Brechungsindexsprung von der zweiten Wellenleiterschicht zur zweiten Mantelschicht weniger abrupt ist, als wenn eine zweite Mantelschicht mit dem Brechungsindex der zweiten Teilschicht direkt an die zweite Wellenleiterschicht angrenzen würde.

Dadurch, dass die erste Teilschicht der zweiten Mantelschicht einen Brechungsindex aufweist, der zwischen dem Brechungsindex der zweiten Wellenleiterschicht und dem Brechungsindex der zweiten Teilschicht der zweiten Mantelschicht liegt, wird erreicht, dass ein größerer Anteil der Laserstrahlung zumindest in die erste Teilschicht der zweiten Mantelschicht eindringt als im Fall einer abrupten Änderung des Brechungsindex von dem Brechungsindex der zweiten Wellenleiterschicht zum Brechungsindex der zweiten Teilschicht der zweiten Mantelschicht. Die Wirkung einer Phasenstruktur auf die lateralen Lasermoden, die einen vergleichsweise großen Überlapp mit der zweiten Mantelschicht aufweisen, wird auf diese Weise vorteilhaft erhöht. Dies erleichtert insbesondere den Einsatz von Phasenstrukturen in Halbleiterlasern mit vergleichsweise dicken zweiten Mantelschichten, insbesondere in im infraroten Spektralbereich emittierenden Halbleiterlasern.

Es ist auch möglich, dass die zweite Mantelschicht mehr als nur zwei Teilschichten aufweist. Insbesondere kann die zweite Mantelschicht mehrere Teilschichten aufweisen, deren Brechungsindex in Wachstumsrichtung des Halbleiterkörpers von der zweiten Wellenleiterschicht aus stufenförmig abnimmt. Alternativ kann die zweite Mantelschicht auch einen Brechungsindexgradienten aufweisen, wobei der Brechungsindex in Wachstumsrichtung kontinuierlich abnimmt.

Weiterhin ist es auch möglich, dass auch die erste Mantelschicht, die in Wachstumsrichtung des Halbleiterkörpers unterhalb des Wellenleiterbereichs angeordnet ist, aus zwei oder mehreren Teilschichten zusammengesetzt ist. Beispielsweise kann die erste Mantelschicht eine an die erste Wellenleiterschicht angrenzende erste Teilschicht, die einen geringeren Brechungsindex als die erste Wellenleiterschicht aufweist, und eine zweite Teilschicht, die einen geringeren Brechungsindex als die erste Teilschicht aufweist, enthalten. Der Brechungsindex nimmt also von der ersten Wellenleiterschicht zur zweiten Teilschicht der ersten Mantelschicht hin stufenweise ab.

Bei einer weiteren vorteilhaften Ausgestaltung ist die Phasenstruktur mit einer Deckschicht versehen. Die Ausnehmungen, welche die Phasenstruktur ausbilden, sind beispielsweise ganz oder teilweise von dem Material der Deckschicht aufgefüllt. Insbesondere ist es auch möglich, dass die Ausnehmungen der Phasenstruktur von der Deckschicht vollständig planarisiert werden.

Bei der Deckschicht kann es sich insbesondere um eine Passivierungsschicht handeln, die zum Beispiel ein Siliziumoxid, ein Siliziumnitrid, ein Siliziumoxinitrid, ein Aluminiumoxid, Zinkselenid, Germanium oder Benzocyclobuten (BCB) enthalten kann. Die Deckschicht weist vorzugsweise einen Brechungsindex auf, der kleiner ist als der Brechungsindex der zweiten Mantelschicht. Dadurch, dass die Deckschicht einen Brechungsindex zwischen dem Brechungsindex von Luft und dem Brechungsindex des Halbleitermaterials der zweiten Mantelschicht aufweist, wird der Brechungsindexsprung an den Grenzflächen der Ausnehmungen gegenüber nur mit Luft gefüllten Ausnehmungen verringert. Auf diese Weise werden Koppelverluste an den Grenzflächen der Ausnehmungen vermindert.

Alternativ ist es aber auch möglich, dass die Phasenstruktur mit einer Deckschicht versehen wird, die einen größeren Brechungsindex als das Halbleitermaterial aufweist. In diesem Fall kann die Deckschicht beispielsweise Germanium enthalten.

Bei einer vorteilhaften Ausgestaltung ist auf eine Oberfläche des Halbleiterlasers mindestens ein Kontaktstreifen aufgebracht. Der Kontaktstreifen ist vorzugsweise an der Oberseite des Halbleiterkörpers angeordnet. Bei dem Kontaktstreifen kann es sich um eine Elektrode handeln, über die elektrischer Strom in den Halbleiterkörper eingeprägt werden kann. Diese kann zum Beispiel als streifenförmige Metallisierung auf die Oberseite des Halbleiterkörpers aufgebracht sein. Darüber hinaus ist es auch möglich, dass der Kontaktstreifen mittels eines streifenförmigen Durchbruchs in einer Passivierungsschicht auf der Oberseite des Halbleiterkörpers definiert ist. Auf diese Passivierung kann eine Metallschicht großflächig aufgebracht sein. Die Metallschicht befindet sich dann nur im Bereich des Durchbruchs in Kontakt mit dem Halbleiterkörper.

Mittels des eingeprägten elektrischen Stroms wird in der aktiven Schicht des Halbleiterkörpers elektromagnetische Strahlung erzeugt. Bei dem kantenemittierenden Halbleiterlaser handelt es sich also um einen elektrisch gepumpten Halbleiterlaser.

Die elektromagnetische Strahlung wird in der aktiven Zone unterhalb des Kontaktstreifens erzeugt. Dort befindet sich also der Emissionsbereich des Halbleiterlasers. Weist der Halbleiterlaser mehrere Kontaktstreifen an der Oberseite des Halbleiterkörpers auf, so wird unterhalb eines jeden Kontaktstreifens Laserstrahlung erzeugt. Der Halbleiterlaser weist dann mehrere Emissionsbereiche auf, deren Zahl der Anzahl der Kontaktstreifen auf der Oberseite entspricht. Der mindestens eine Kontaktstreifen erstreckt sich vorzugsweise entlang der Hauptstrahlrichtung der in der aktiven Zone erzeugten elektromagnetischen Strahlung. Die Haupterstreckungsrichtung des Kontaktstreifens ist dann parallel zur Hauptstrahlrichtung des Emitters, der dem Kontaktstreifen zugeordnet ist. Beispielsweise erstreckt sich der Kontaktstreifen als Streifen gleichmäßiger Breite entlang der Hauptstrahlrichtung der im Halbleiterkörper erzeugten elektromagnetischen Strahlung.

Der mindestens eine Kontaktstreifen des kantenemittierenden Halbleiterlasers weist vorteilhaft eine Breite zwischen einschließlich 10 $\mu$m und einschließlich 500 $\mu$m auf. Insbesondere handelt es sich bei dem kantenemittierenden Halbleiterlaser also um einen so genannten Breitstreifenlaser.

Bei einer bevorzugten Ausführungsform weist der kantenemittierende Halbleiterlaser mehrere Kontaktstreifen an der Oberfläche auf. Die mehreren Kontaktstreifen sind bevorzugt parallel zueinander auf der Oberfläche des Halbleiterkörpers angeordnet und vorteilhaft in jeweils gleichen Abständen zueinander angeordnet. Bei dem kantenemittierenden Halbleiterlaser handelt es sich in diesem Fall um einen so genannten Laserbarren.

Bevorzugt weisen die Kontaktstreifen des Halbleiterlasers einen Abstand d und eine Breite b auf, wobei gilt: $0,01 \leq b/d \leq 0,5$. Der Abstand der Kontaktstreifen untereinander ist in diesem Fall also mindestens doppelt so groß wie die Breite der Kontaktstreifen. Bei einem derartigen Halbleiterlaser ist es besonders vorteilhaft, mittels der Phasenstruktur einen Betrieb in der lateralen Grundmode und eine geringe Strahldivergenz zu erzielen, um die voneinander beabstandeten emittierten Laserstrahlen in eine oder mehrere Lichtleitfasern einkoppeln zu können. Beispielsweise kann ein Lasersystem den hierin beschriebenen kantenemittierenden Halbleiterlaser und mindestens eine Lichtleitfaser umfassen, wobei der Halbleiterlaser einen oder mehrere Laserstrahlen emittiert, die mittels eines oder mehrerer optischer Elemente, die zwischen dem Halbleiterlaser und der Lichtleitfaser angeordnet sind, in die Lichtleitfaser eingekoppelt werden.

Bei dem Halbleiterlaser kann es sich insbesondere um einen im infraroten Spektralbereich emittierenden Halbleiterlaser handeln. Vorzugsweise weist der Halbleiterlaser eine Emissionswellenlänge zwischen 780 nm und 1500 nm auf.

Die Erfindung wird im Folgenden anhand von Vergleichsbeispielen und Ausführungsbeispielen in Zusammenhang mit den Figuren 1 bis 5 näher erläutert.

Es zeigen:

Figur 1A eine schematische Darstellung eines Querschnitts durch ein Vergleichsbeispiel eines kantenemittierenden Halbleiterlasers,

Figur 1B eine schematische Darstellung einer Aufsicht auf das in Figur 1A dargestellte Vergleichsbeispiel,

Figur 2A eine schematische Darstellung eines Querschnitts durch ein weiteres Vergleichsbeispiel eines kantenemittierenden Halbleiterlasers,

Figur 2B eine schematische Darstellung einer Aufsicht auf das in Figur 2A dargestellte Vergleichsbeispiel,

Figur 3A eine schematische Darstellung eines Querschnitts durch ein Ausführungsbeispiel eines kantenemittierenden Halbleiterlasers,

Figur 3B eine schematische Darstellung einer Aufsicht auf das in Figur 3A dargestellte Ausführungsbeispiel,

Figur 4 eine schematische Darstellung einer Aufsicht auf ein weiteres Ausführungsbeispiel eines kantenemittierenden Halbleiterlasers, und

Figur 5 eine graphische Darstellung des Verlaufs des Brechungsindex n in vertikaler Richtung z in dem Halbleiterkörper bei einem weiteren Ausführungsbeispiel eines kantenemittierenden Halbleiterlasers.

Gleiche oder gleich wirkende Bestandteile sind in den Figuren mit den gleichen Bezugszeichen versehen. Die dargestellten Bestandteile sowie die Größenverhältnisse der Bestandteile untereinander sind nicht als maßstabsgerecht anzusehen.

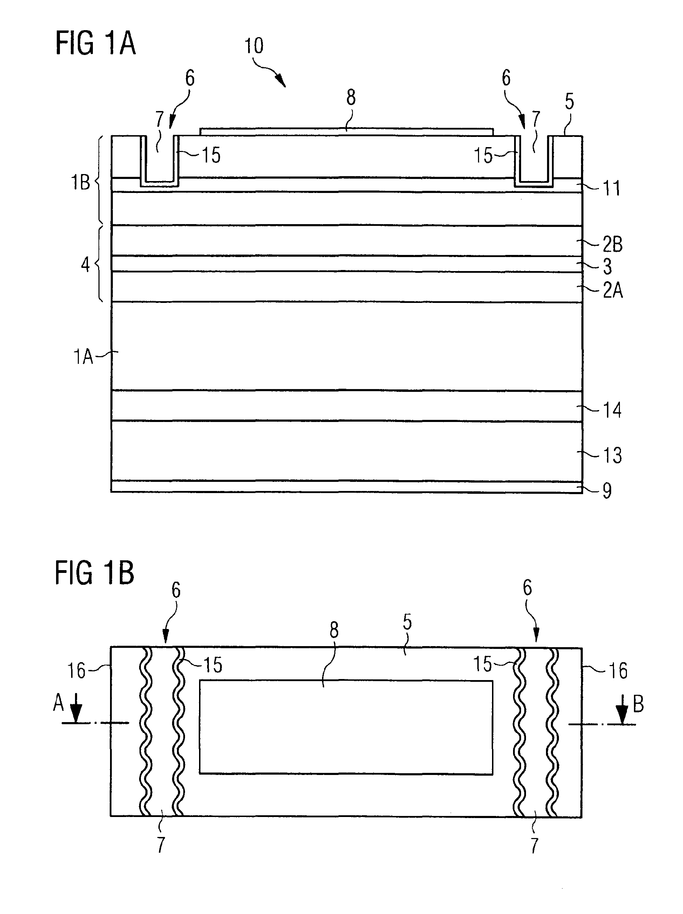

In den Figuren 1A und 1B ist ein erstes Vergleichsbeispiel eines kantenemittierenden Halbleiterlasers dargestellt. Figur 1A zeigt einen Querschnitt entlang der Linie A-B der in Figur 1B dargestellten Aufsicht.

Der kantenemittierende Halbleiterlaser weist einen Halbleiterkörper 10 auf, in dem ein Wellenleiterbereich 4 enthalten ist. Der Wellenleiterbereich 4 umfasst eine erste Wellenleiterschicht 2A und eine zweite Wellenleiterschicht 2B, zwischen denen eine zur Erzeugung von Laserstrahlung vorgesehene aktive Schicht 3 angeordnet ist.

Bei der aktiven Schicht 3 des kantenemittierenden Halbleiterlasers kann es sich insbesondere um eine Einfach- oder Mehrfachquantentopfstruktur handeln.

Die Wellenleiterschichten 2A, 2B mit der dazwischen eingebetteten aktiven Schicht 3 bilden den Wellenleiterbereich 4 aus. Der Wellenleiterbereich 4 ist zwischen einer ersten Mantelschicht 1A und einer dem Wellenleiterbereich 1B in Wachstumsrichtung des Halbleiterkörpers 10 nachfolgenden zweiten Mantelschicht 1B angeordnet. Die erste Mantelschicht 1A ist auf einer einem Substrat 13 des Halbleiterkörpers 10 zugewandten Seite angeordnet und die zweite Mantelschicht 1B ist auf einer von der aktiven Schicht 3 aus gesehen dem Substrat 13 abgewandten Seite des Halbleiterkörpers 10 angeordnet.

Zwischen dem Substrat 13 des Halbleiterkörpers 10 und der ersten Mantelschicht 1A können eine oder mehrere weitere Schichten, beispielsweise eine Pufferschicht 14, angeordnet sein. Die elektrische Kontaktierung des kantenemittierenden Halbleiterlasers erfolgt beispielsweise durch eine erste elektrische Kontaktschicht 8 an einer Oberseite 5 des Halbleiterkörpers 10 und eine zweite elektrische Kontaktschicht 9 an einer Rückseite des Substrats 13. Zwischen der zweiten Mantelschicht 1B und der ersten elektrischen Kontaktschicht 8 können eine oder mehrere weitere Halbleiterschichten (nicht dargestellt) angeordnet sein.

Die Mantelschichten 1A, 1B weisen vorteilhaft einen geringeren Brechungsindex als die Wellenleiterschichten 2A, 2B auf, wodurch die sich in lateraler Richtung ausbreitende Laserstrahlung im Wesentlichen in dem Wellenleiterbereich 4 geführt wird. Wegen des endlichen Brechungsunterschieds zwischen den Wellenleiterschichten 2A, 2B und den Mantelschichten 1A, 1B breiten sich die Lasermoden aber auch zumindest teilweise bis in die Mantelschichten 1A, 1B aus. Daher ist es möglich, die sich in dem Wellenleiterbereich 4 ausbreitenden Lasermoden durch eine Änderung der Eigenschaften der Mantelschichten 1A, 1B zu beeinflussen. Der Halbleiterkörper 10 weist Phasenstrukturen 6 auf, die in der zweiten Mantelschicht 1B ausgebildet sind. Die Phasenstruktur 6 umfasst zwei Ausnehmungen 7, die sich von der Oberseite 5 des Halbleiterkörpers 10 in die erste Mantelschicht 1B hinein erstrecken. Die Phasenstruktur 6 befindet sich in einem von der ersten Kontaktschicht 8 ausgesparten Bereich der zweiten Mantelschicht 1B. Alternativ wäre es aber auch möglich, die Phasenstruktur 6 zumindest teilweise unterhalb der ersten Kontaktschicht 8 anzuordnen.

Durch die Phasenstrukturen 6 kann die Ausbreitung der Lasermoden gezielt beeinflusst werden, wobei insbesondere erreicht werden kann, dass höhere laterale Moden stärkere Umlaufverluste in dem zwischen den Seitenfacetten des Halbleiterkörpers angeordnetem Laserresonator aufweisen als die laterale Grundmode des Halbleiterlasers. Durch eine geeignete Ausbildung der Phasenstrukturen 6 kann daher insbesondere ein Betrieb des Halbleiterlasers in einer oder mehreren bevorzugte Moden, insbesondere nur in der lateralen Grundmode, erreicht werden. Weiterhin ist es durch die Phasenstrukturen 6 auch möglich, das Strahlprofil der lateralen Grundmode zu formen. Insbesondere kann erreicht werden, dass die Strahlung der lateralen Grundmode eine geringe Strahldivergenz aufweist. Dies ist insbesondere vorteilhaft für Anwendungen, bei denen die von dem Halbleiterlaser emittierte Strahlung in eine Lichtleitfaser eingekoppelt werden soll.

Die Berechnung der dreidimensionalen Struktur der Phasenstrukturen 6 derart, dass eine gewünschte Beeinflussung des lateralen Modenspektrums erreicht wird, ist an sich aus der Druckschrift WO 01/97349 A1 bekannt, deren Offenbarungsgehalt diesbezüglich hiermit durch Rückbezug aufgenommen wird. Die Phasenstruktur 6 kann unter Einbeziehung der Parameter der Materialien der Halbleiterschichtenfolge, der geometrischen Abmessungen und der Wellenlänge der emittierten Strahlung derart voraus berechnet werden, dass höhere laterale Lasermoden größere Umlaufverluste in dem durch die Seitenfacetten 16 ausgebildeten Laserresonator erfahren als niedrigere laterale Moden, insbesondere die laterale Grundmode des Halbleiterlasers. Beispielsweise kann der Abstand zwischen den jeweiligen Seitenfacetten 16 des Halbleiterlasers und den Ausnehmungen 7 in der zweiten Mantelschicht 1B, die die Phasenstruktur 6 ausbilden, in der Ebene der zweiten Mantelschicht 1B einen wellenförmigen Verlauf annehmen, wie es in der Aufsicht in Figur 1B dargestellt ist.

Die Ausnehmungen 7, die sich von der Oberseite des Halbleiterkörpers 5 in die zweite Mantelschicht 1B hinein erstrecken, werden vorteilhaft durch einen Ätzprozess in dem Halbleiterkörper 10 ausgebildet. Dabei kann es erforderlich sein, vergleichsweise tiefe Ausnehmungen 7 in den Halbleiterkörper 10 zu ätzen, um die gewünschte Beeinflussung des lateralen Modenprofils zu erzielen. Insbesondere bei im infraroten Spektralbereich emittierenden Halbleiterlasern, die sich durch eine starke Konzentration der Lasermoden auf den Wellenleiterbereich 4 und/oder eine vergleichsweise dicke zweite Mantelschicht 1B auszeichnen, kann es erforderlich sein, die Ausnehmungen 7 derart tief in den Halbleiterkörper 10 zu ätzen, dass sie bis in die Nähe des Wellenleiterbereichs 4 reichen. Dabei muss die gewünschte Ätztiefe möglichst genau erreicht werden und gut reproduzierbar sein.

Um die genaue und reproduzierbare Herstellung der Ausnehmungen 7 in der zweiten Mantelschicht 1B zu erleichtern, ist in die zweite Mantelschicht 1B vorteilhaft eine Zwischenschicht 11 eingebettet, die aus einem von dem Halbleitermaterial der zweiten Mantelschicht 1B verschiedenen Halbleitermaterial besteht. Die Zwischenschicht 11 unterscheidet sich in ihrer chemischen Zusammensetzung von der zweiten Mantelschicht 1B und weist insbesondere ein Material der dritten oder fünften Hauptgruppe des Periodensystems auf, das in der zweiten Mantelschicht 1B nicht enthalten ist. Die zweite Mantelschicht 1B kann insbesondere eine Schicht aus $Al_xGa_{1-x}As$ mit $0 < x < 1$ sein. In diesem Fall ist die Zwischenschicht 11 vorteilhaft aus einem III-V-Halbleitermaterial gebildet, welches ein anderes Material der dritten oder fünften Hauptgruppe als Al, Ga oder As enthält. Vorzugsweise weist die Zwischenschicht 11 In oder P auf. Beispielsweise kann das Material der Zwischenschicht 11 InGaP, InGaAs oder InGaAlP enthalten. In diesem Fall enthält die zweite Mantelschicht 1B vorzugsweise weder In noch P.

Die Zwischenschicht 11 fungiert beim Ätzprozess vorteilhaft als Indikatorschicht für das Erreichen einer gewünschten Ätztiefe. Die Zwischenschicht 11 wird also beim Aufwachsen der zweiten Mantelschicht 1B in der Tiefe in die zweite Mantelschicht 1B eingebaut, bis zu der die Ausnehmungen 7 der Phasenstruktur 6 reichen sollen. Das Ätzen kann mit einem nasschemischen Ätzprozess oder mit einem Trockenätzprozess erfolgen, oder es kann auch eine Kombination aus einem nasschemischen und einem Trockenätzprozess eingesetzt werden. Insbesondere bei einem nasschemischen Ätzprozess kann die Zwischenschicht 11 als Ätzstoppschicht fungieren, wobei eine Ätzlösung verwendet wird, die für das Material der zweiten Mantelschicht 1B eine größere Ätzrate aufweist als für das Material der Zwischenschicht 11. Bei einem Trockenätzprozess dient vorteilhaft die Detektion eines Elements in der Zwischenschicht 11, das in der zweiten Mantelschicht nicht enthalten ist, als Indikator für das Erreichen der gewünschten Ätztiefe. Während des Ätzprozesses wird daher eine Messvorrichtung eingesetzt, welche das Auftreten eines nur in der Zwischenschicht 11 enthaltenen chemischen Elements detektieren kann. Beispiel kann bei einem Plasmaätzprozess mittels der Überwachung der optischen Emission des Plasmas in der Prozesskammer während des Ätzens das Element detektiert werden und so das Erreichen der Zwischenschicht 11 festgestellt werden. Somit kann an dieser Stelle der Ätzprozess gezielt gestoppt werden.

Die Ausnehmungen 7 erstrecken sich mindestens bis in die Zwischenschicht 11. Vorzugsweise enden die Ausnehmungen 7 in der Zwischenschicht 11. Es ist aber auch möglich, dass sich die Ausnehmungen geringfügig tiefer in den Halbleiterkörper 10 erstrecken als bis in die Zwischenschicht 11. Dieser Fall kann insbesondere dann auftreten, wenn die Zwischenschicht 11 vergleichsweise dünn ist und zwischen der Detektion des in ihr enthaltenen charakteristischen Elements und dem Stoppen des Ätzprozesses eine zumindest geringfügige Zeitverzögerung auftritt.

Als Zwischenschicht 11 wird vorzugsweise eine im Vergleich zur zweiten Mantelschicht 1B sehr dünne Schicht verwendet. Die Dicke der Zwischenschicht 11 beträgt bevorzugt zwischen 10 nm und 100 nm, besonders bevorzugt zwischen 20 nm und 50 nm. Im Gegensatz dazu kann die zweite Mantelschicht 1B eine Dicke von beispielsweise 1 μm oder mehr aufweisen. Aufgrund der geringen Dicke der Zwischenschicht 11 wird die Ausbreitung der Lasermoden nur geringfügig von der Zwischenschicht 11 beeinflusst. Daher ist es möglich, für die Zwischenschicht 11 ein Material zu verwenden, das sich in seinem Brechungsindex von dem Material der zweiten Mantelschicht 1B unterscheidet.

Die Phasenstruktur 6 kann zumindest teilweise mit einer Deckschicht 15 versehen sein. Wie in Figur 1A dargestellt, können beispielsweise die Seitenflanken und die Bodenfläche der Ausnehmungen 7 von der Deckschicht 15 bedeckt sein. Alternativ ist es auch möglich, dass die Ausnehmungen 7 teilweise oder vollständig von der Deckschicht 15 aufgefüllt werden. Die Deckschicht 7 weist vorzugsweise ein elektrisch isolierendes Material wie beispielsweise ein Siliziumoxid, ein Siliziumnitrid, ein Siliziumoxinitrid oder Benzocyclobuten (BCB) auf.

Die erste Kontaktschicht 8 des Halbleiterkörpers 10 ist vorzugsweise als Kontaktstreifen ausgeführt. Der Kontaktstreifen 8 verläuft mit seiner Längsrichtung senkrecht zu den Seitenfacetten 16 des Halbleiterlasers und definiert den Bereich, in den Strom zur Erzeugung von Laserstrahlung in den Halbleiterkörper 10 eingeprägt wird. Wie in Figur 1B dargestellt, können die Phasenstrukturen 6 beispielsweise in einem Randbereich in der Nähe der Seitenfacetten 16 des Halbleiterkörpers 10 ausgebildet sein, wobei sich der Kontaktstreifen 8 zwischen den Phasenstrukturen 6 befindet. Es ist aber auch möglich, dass der Kontaktstreifen 8 über den Phasenstrukturen 6 verläuft. Dies kann insbesondere dann der Fall sein, wenn die Ausnehmungen 7 von einer Deckschicht 15 aufgefüllt sind. Anders als in Fig. 1A und 1B können sich die Phasenstrukturen auch bis zu den Seitenfacetten 16 des Halbleiterlasers erstrecken.

Der Kontaktstreifen 8 kann eine streifenförmige Metallisierung auf der Oberseite 5 des Halbleiterkörpers 10 sein. Alternativ ist es aber auch möglich, dass die Oberseite 5 des Halbleiterkörpers mit einer Passivierungsschicht versehen ist, wobei die Passivierungsschicht eine Öffnung aufweist, die den Kontaktstreifen 8 definiert (nicht dargestellt). In diesem Fall kann die Passivierungsschicht großflächig mit einer Metallisierung wie beispielsweise einer Goldschicht bedeckt sein, wobei der Kontakt zum Halbleiterkörper 10 nur im Bereich der Öffnung, die den Kontaktstreifen 8 definiert, hergestellt ist.

Der Kontaktstreifen 8 weist bevorzugt eine Breite zwischen 10 μm und 500 μm auf. Insbesondere kann es sich bei dem kantenemittierenden Halbleiterlaser also um einen Breitstreifenlaser handeln.

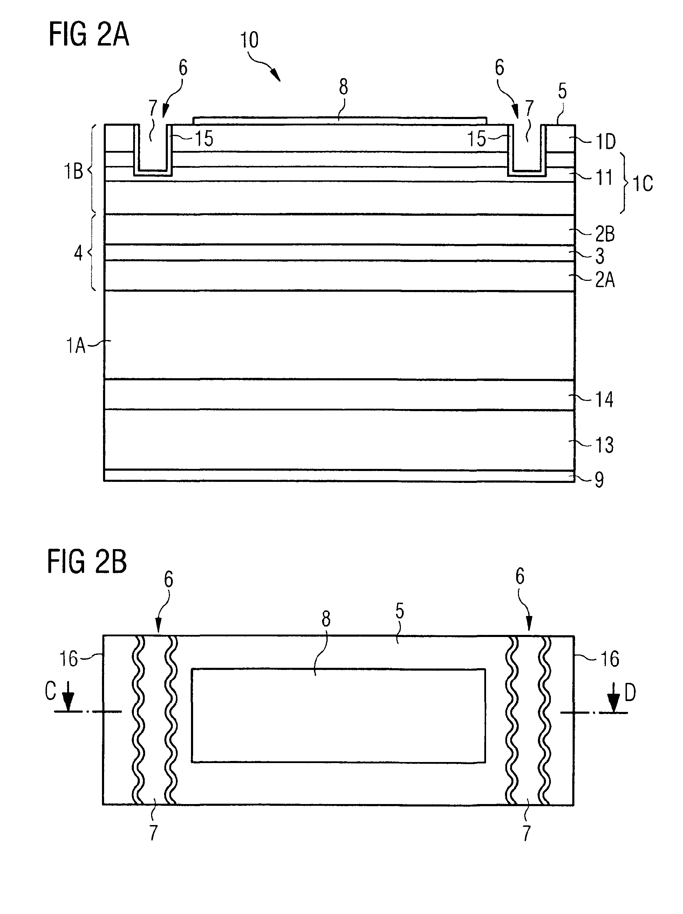

Das in Fig. 2B in einer Aufsicht und in Fig. 2A in einem Querschnitt entlang der Linie C-D der Aufsicht dargestellte zweite Vergleichsbeispiel eines kantenemittierenden Halbleiterlasers unterscheidet sich von dem ersten Vergleichsbeispiel dadurch, dass die zweite Mantelschicht 1B aus einer ersten Teilschicht 1C und einer zweiten Teilschicht 1D zusammengesetzt ist. Die erste Teilschicht 1C grenzt an den Wellenleiterbereich 4 an und die zweite Teilschicht 1D ist oberhalb der ersten Teilschicht 1C angeordnet. Bei dieser Ausführungsform weist die erste Teilschicht 1C der zweiten Mantelschicht 1B einen größeren Brechungsindex als die zweite Teilschicht 1D auf. Der Brechungsindex der ersten Teilschicht 1C liegt also zwischen dem Brechungsindex der zweiten Wellenleiterschicht 2B und der zweiten Teilschicht 1D.

Dadurch, dass die erste Teilschicht 1C der zweiten Mantelschicht 1B einen Brechungsindex aufweist, der zwischen dem Brechungsindex der zweiten Wellenleiterschicht 2A und dem Brechungsindex der zweiten Teilschicht 1D der zweiten Mantelschicht 1B liegt, wird erreicht, dass ein größerer Anteil der Laserstrahlung zumindest in die erste Teilschicht 1C der zweiten Mantelschicht 1B eindringt als im Fall einer abrupten Änderung des Brechungsindex von dem Brechungsindex der zweiten Wellenleiterschicht 2A zum Brechungsindex der zweiten Teilschicht 1D der zweiten Mantelschicht 1B. Die Wirkung einer Phasenstruktur auf die lateralen Lasermoden, die einen vergleichsweise großen Überlapp mit der zweiten Mantelschicht 1B aufweisen, wird auf diese Weise vorteilhaft erhöht. Dies erleichtert insbesondere den Einsatz von Phasenstrukturen in Halbleiterlasern mit vergleichsweise dicken zweiten Mantelschichten 1B, insbesondere in im infraroten Spektralbereich emittierenden Halbleiterlasern.

Die Zwischenschicht 11, die wie bei dem ersten Ausführungsbeispiel zur definierten Einstellung der Tiefe der Ausnehmungen 7 der Phasenstrukturen 6 dient, ist vorzugsweise in die erste Teilschicht 1C der zweiten Mantelschicht 1B angeordnet. Auf diese Weise können Ausnehmungen 7 hergestellt werden, die sich bis in die an den Wellenleiterbereich 4 angrenzende erste Teilschicht 1C erstrecken. Alternativ wäre es aber auch denkbar, die Zwischenschicht 11 in die zweite Teilschicht 1D einzubetten oder zwischen der ersten Teilschicht 1C und der zweiten Teilschicht 1D anzuordnen.

Ansonsten entspricht das zweite Vergleichsbeispiel hinsichtlich seiner Funktionsweise und der vorteilhaften Ausgestaltungen dem ersten Vergleichsbeispiel.

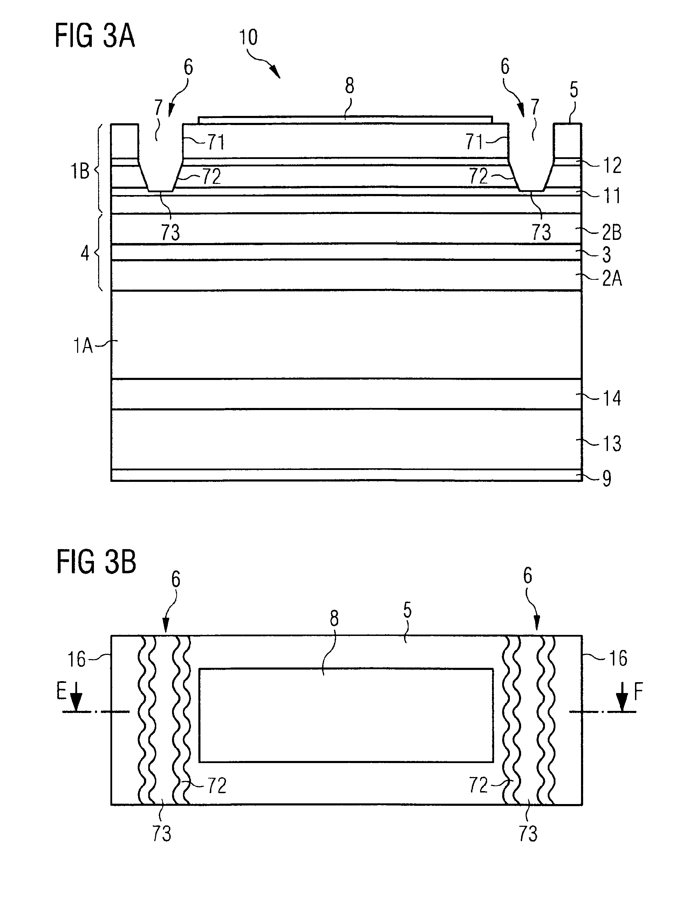

Bei dem in Fig. 3B in einer Aufsicht und in Fig. 3A in einem Querschnitt entlang der Linie E-F der Aufsicht dargestellten Ausführungsbeispiel eines kantenemittierenden Halbleiterlasers gemäß der Erfindung ist zusätzlich zu der ersten Zwischenschicht 11 eine zweite Zwischenschicht 12 in die zweite Mantelschicht 1B eingebettet. Die zweite Zwischenschicht 12 entspricht hinsichtlich ihrer Funktionsweise und vorteilhaften Ausgestaltungen der im Zusammenhang mit dem ersten Ausführungsbeispiel beschriebenen ersten Zwischenschicht 11. Wie die erste Zwischenschicht 11 ist auch die zweite Zwischenschicht 12 vorteilhaft eine zwischen 10 nm und 100 nm, vorzugsweise zwischen 20 nm und 50 nm, dicke Schicht, die aus einem von dem Halbleitermaterial der ersten Mantelschicht verschiedenen Halbleitermaterial besteht, dass mindestens ein Element der dritten oder fünften Hauptgruppe aufweist, das in der zweiten Mantelschicht 1B nicht enthalten ist.

Das Einbetten der zusätzlichen zweiten Zwischenschicht 12 in die zweite Mantelschicht 1B erleichtert die Herstellung von Phasenstrukturen 6, die eine räumlich variierende Tiefe in der zweiten Mantelschicht 1B aufweisen. Bei dem in Figur 3A im Querschnitt dargestellten Ausführungsbeispiel erstrecken sich die Ausnehmungen 7 an ihren Seitenflanken 71 bis in die zweite Zwischenschicht 12 und an ihrer Grundfläche 73 bis in die erste Zwischenschicht 11. Zwischen den Seitenflanken 71 und der Grundfläche 73 weisen die Ausnehmungen 7 schräge Seitenflanken 72 auf. Im Bereich der schrägen Seitenflanken 72 variiert die Tiefe der Ausnehmungen 7 kontinuierlich, insbesondere linear.

Derartige Ausnehmungen 7 können beispielsweise dadurch hergestellt werden, dass zunächst bis zum Erreichen der zweiten Zwischenschicht 12, die oberhalb der ersten Zwischenschicht 11 in der zweiten Mantelschicht 1B angeordnet ist, ein erster Ätzprozess angewandt wird, der steile und vorzugsweise senkrechte Seitenflanken 71 erzeugt. Nachfolgend wird mit einem zweiten Ätzprozess, der schräge Seitenflanken 72 erzeugt, bis zur zweiten Zwischenschicht 12 weitergeätzt. Insbesondere kann als erster Ätzprozess ein nasschemischer Ätzprozess und als zweiter Ätzprozess ein Trockenätzprozess verwendet werden. Alternativ sind auch andere Varianten denkbar, beispielsweise zwei aufeinander folgende nasschemische Ätzprozesse mit verschiedenen Ätzlösungen oder zwei aufeinander folgende Trockenätzprozesse.

Auf diese Weise können vorteilhaft Phasenstrukturen 6 erzeugt werden, bei denen der Brechungsindexunterschied zwischen der Phasenstruktur 6 und dem übrigen Halbleiterkörper 10 weniger abrupt ist, als bei Ausnehmungen mit konstanter Tiefe. Dadurch werden Koppelverluste, die beim Übertritt der Laserstrahlung von dem Hauptbereich in den Phasenstruktur 6 des Halbleiterkörpers 10 auftreten können, verringert, wodurch sich vorteilhaft die Effizienz des Halbleiterlasers verbessert.

Ansonsten entspricht das Ausführungsbeispiel der Figuren 3A und 3B hinsichtlich seiner Funktionsweise und der vorteilhaften Ausgestaltungen dem ersten Vergleichsbeispiel.

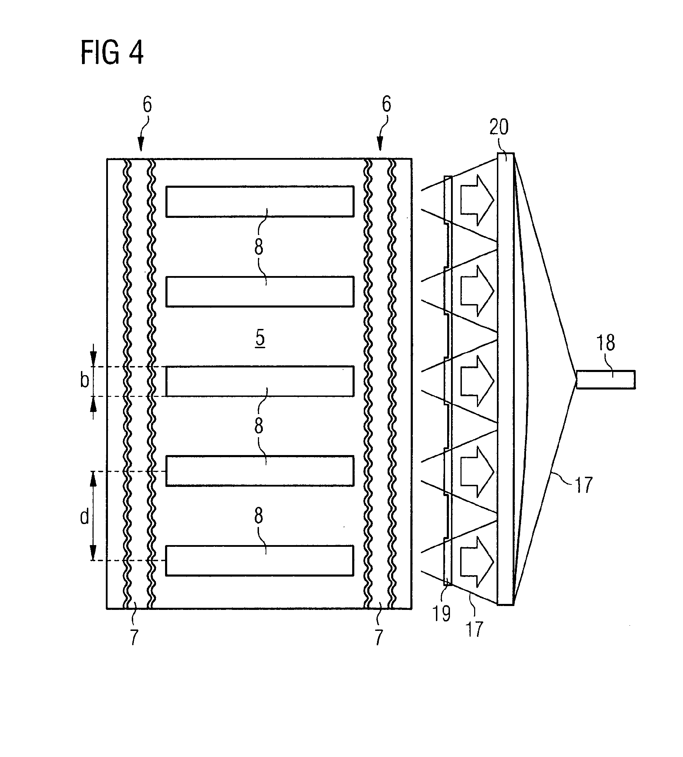

Bei dem in Figur 4 schematisch in einer Aufsicht dargestellten Ausführungsbeispiel ist der kantenemittierende Halbleiterlaser ein Laserbarren, der an der Oberseite 5 des Halbleiterkörpers 10 mehrere Kontaktstreifen 8 aufweist. Die Kontaktreifen 8 verlaufen parallel zueinander und mit ihrer Längsrichtung senkrecht zu den Seitenfacetten 16 des Halbleiterlasers. Die Kontaktstreifen 8 sind zum Beispiel zwischen den Phasenstrukturen 6 und den Seitenflanken 16 des Halbleiterkörpers 10 angeordnet. Der Halbleiterkörper 10 und die darin enthaltenen Phasenstrukturen 6 können wie bei den zuvor beschriebenen Vergleichs- und Ausführungsbeispielen ausgeführt sein und werden daher nicht nochmals näher erläutert.

Durch die mehreren Kontaktstreifen 8 wird jeweils ein Strom zum elektrischen Pumpen der aktiven Schicht des Halbleiterlasers in den Halbleiterkörper 10 geleitet. Die aktive Schicht des Laserbarrens weist daher mehrere Emissionsbereiche auf, die jeweils unterhalb der Kontaktstreifen 8 angeordnet sind. Bei dem dargestellten Ausführungsbeispiel beträgt die Anzahl der Kontaktreifen 8 und der Emissionsbereiche fünf.

Die Kontaktstreifen 8 weisen vorzugsweise jeweils die gleiche Breite b und den gleichen Abstand d voneinander auf. Die Breite b der Kontaktstreifen 8 kann beispielsweise zwischen 10 $\mu$m und 500 $\mu$m betragen. Für die Abstände d der Mitten der Kontaktstreifen gilt vorzugsweise $0{,}01 \leq b/d \leq 0{,}5$. Wenn die Kontaktreifen zum Beispiel eine Breite von 100 $\mu$m aufweisen, beträgt der Abstand d mindestens 200 $\mu$m. Ein Laserbarren mit einem derartigen Verhältnis der Breiten b zu den Abständen d der Kontaktstreifen 8 ist besonders gut zur Einkopplung der mehreren emittierten Laserstrahlen 17 in eine Lichtleitfaser 18 geeignet. Die Einkopplung der Laserstrahlen 17 in die Lichtleitfaser 18 kann mit einem oder mehreren optischen Elementen 19, 20 erfolgen. Beispielsweise kann das erste optische Element 19 eine Mikrolinsenarray sein, bei dem jedem Emissionsbereich eine Mikrolinse zugeordnet ist, die eine Strahlformung des jeweiligen Laserstrahls 17 bewirkt. Die mehreren Strahlen können zum Beispiel mit einem weiteren optischen Element, beispielsweise einer Linse 20, gebündelt und in die Lichtleitfaser 18 eingekoppelt werden.

Für eine derartige Anwendung, bei der die Strahlung des Halbleiterlasers in eine Lichtleitfaser 18 eingekoppelt wird, ist der mit den Phasenstrukturen 6 versehene Halbleiterkörper 10 besonders gut geeignet, weil durch die Phasenstrukturen 6 eine geringe Strahldivergenz sowohl in vertikaler als auch in horizontaler Strahlrichtung erzielt werden kann. Es können daher vergleichsweise einfache optische Elemente 19, 20 wie zum Beispiel sphärische Linsen anstelle aufwändiger asphärischer optischer Elemente eingesetzt werden, oder es kann sogar auf eines oder sogar alle optischen Elemente 19, 20 verzichtet werden.

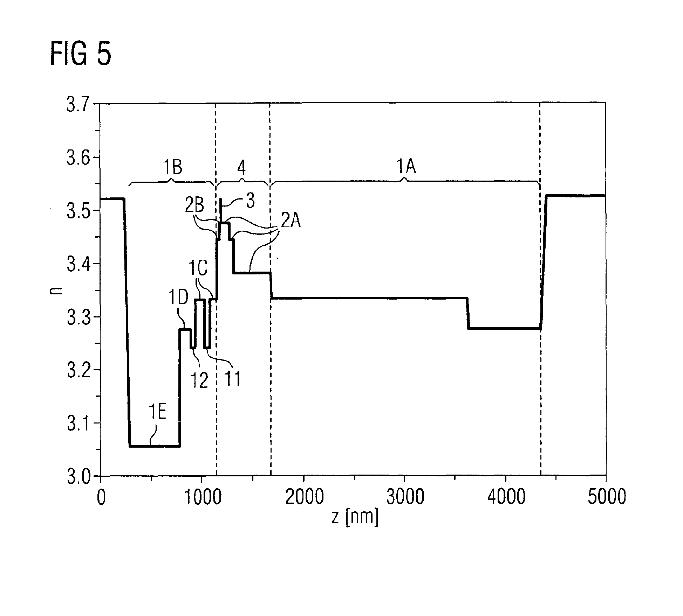

In Figur 5 ist schematisch der Verlauf des Brechungsindex n bei einem weiteren Ausführungsbeispiel eines kantenemittierenden Halbleiterlasers entlang einer Ortskoordinate z dargestellt, die von der Oberseite des Halbleiterkörpers in Richtung des Substrats verläuft.

Der kantenemittierende Halbleiterlaser weist eine erste Mantelschicht 1A, eine zweite Mantelschicht 1B und einen dazwischen angeordneten Wellenleiterbereich 4 auf. Der Wellenleiterbereich 4 umfasst eine aktive Schicht 3, bei der es sich um eine Quantentopfschicht handelt, sowie die erste Wellenleiterschicht 2A und die zweite Wellenleiterschicht 2B.

Wie dem stufenförmigen Verlauf des Brechungsindex zu entnehmen ist, sind die Wellenleiterschichten 2A, 2B und die Mantelschichten 1A, 1B jeweils aus mehreren Teilschichten zusammengesetzt. Beispielsweise umfassen die erste Mantelschicht 1A zwei Teilschichten, die erste Wellenleiterschicht 2A drei Teilschichten und die zweite Wellenleiterschicht 2B zwei Teilschichten. Die zweite Mantelschicht 1B weist drei Teilschichten 1C, 1D, 1E auf. In den Teilschichten der Wellenleiter- und Mantelschichten nimmt der Brechungsindex n von der Oberseite des Halbleiterkörpers zu der aktiven Schicht hin stufenweise zu und von der aktiven Schicht 3 in die Richtung des Substrats stufenweise ab.

In die zweite Mantelschicht 1B sind zwei Zwischenschichten 11, 12 eingebettet, die aus einem Halbleitermaterial bestehen, das mindestens ein Element der dritten oder fünften Hauptgruppe aufweist, das in den Teilschichten 1C, 1D und 1E der zweiten Mantelschicht 1B nicht enthalten ist. Zum Beispiel können die Teilschichten 1C, 1D, 1E der zweiten Mantelschicht 1B $Al_xGa_{1-x}As$ mit $0 < x < 1$ aufweisen, wobei die Zwischenschichten 11, 12 ein In und/oder P enthaltendes Halbleitermaterial wie beispielsweise InGaAs, InGaP oder InGaAsP enthalten.

Aufgrund des in ihnen enthaltenen unterschiedlichen chemischen Elements werden die Zwischenschichten 11, 12 nicht als Teilschichten der zweiten Mantelschicht 1B betrachtet. Die Teilschichten 1C, 1D, 1E der zweiten Mantelschicht weisen dagegen die gleichen Bestandteile auf, die aber in unterschiedlicher Konzentration vorliegen können. So können die Teilschichten 1C, 1D, 1E der zweiten Mantelschicht 1B beispielsweise $Al_xGa_{1-x}As$ mit $0 < x < 1$ aufweisen, wobei die Teilschichten einen unterschiedlichen Aluminiumgehalt x aufweisen. Insbesondere kann der Aluminiumgehalt von der Oberseite der zweiten Mantelschicht 1B zur aktiven Schicht 3 hin abnehmen, so dass der Brechungsindex in dieser Richtung von Teilschicht zu Teilschicht zunimmt.

Die erste Zwischenschicht 11 ist in die erste Teilschicht 1C der zweiten Mantelschicht 1B eingebettet. Die zweite Zwischenschicht 12 ist zwischen der ersten Teilschicht 1C und der zweiten Teilschicht 1D angeordnet. Die beiden in die zweite Mantelschicht 1B eingebetteten Zwischenschichten 11, 12 vereinfachen die Herstellung von Phasenstrukturen, die Ausnehmungen mit variabler Tiefe aufweisen, wie zuvor im Zusammenhang mit den Figuren 3A und 3B beschrieben.

Für den Einsatz von Phasenstrukturen in kantenemittierenden Halbleiterlasern, insbesondere in Infrarot-Halbleiterlasern, hat es sich weiterhin als vorteilhaft herausgestellt, die zweite Wellenleiterschicht 2B dünner auszuführen als die erste Wellenleiterschicht 2A. Vorzugsweise weist die zweite Wellenleiterschicht 2B nur die Hälfte der Dicke, besonders bevorzugt nur ein Fünftel oder sogar nur ein Zehntel der Dicke der ersten Wellenleiterschicht 2A auf.

**Patentansprüche**

1. Kantenemittierender Halbleiterlaser mit einem Halbleiterkörper (10), der einen Wellenleiterbereich (4) aufweist, wobei

    - der Wellenleiterbereich (4) eine erste Wellenleiterschicht (2A), eine zweite Wellenleiterschicht (2B) und eine zwischen der ersten Wellenleiterschicht (2A) und der zweiten Wellenleiterschicht (2B) angeordnete aktive Schicht (3) zur Erzeugung von Laserstrahlung aufweist,
    - der Wellenleiterbereich (4) zwischen einer ersten Mantelschicht (1A) und einer dem Wellenleiterbereich (4) in Wachstumsrichtung des Halbleiterkörpers (10) nachfolgenden zweiten Mantelschicht (1B) angeordnet ist,
    - in dem Halbleiterkörper (10) eine Phasenstruktur (6) zur Selektion lateraler Moden der von der aktiven Schicht (3) emittierten Laserstrahlung ausgebildet ist, wobei die Phasenstruktur (6) mindestens eine Ausnehmung (7) umfasst, die sich von einer Oberseite (5) des Halbleiterkörpers (10) in die zweite Mantelschicht (1B) hinein erstreckt,
    - in die zweite Mantelschicht (1B) mindestens eine erste Zwischenschicht (11) aus einem von dem Halbleitermaterial der zweiten Mantelschicht (1B) verschiedenen Halbleitermaterial eingebettet ist,
    - sich die Ausnehmung (7) von der Oberseite (5) des Halbleiterkörpers (10) zumindest teilweise bis in die erste Zwischenschicht (11) erstreckt, und
    - in die zweite Mantelschicht (1B) eine zweite Zwischenschicht (12) eingebettet ist, **dadurch gekennzeichnet, dass**

        - sich die Ausnehmung (7) an mindestens einem ersten Punkt bis in die erste Zwischenschicht (11) erstreckt, und sich an einem mindestens einem zweiten Punkt bis in die zweite Zwischenschicht (12) erstreckt, wobei die Ausnehmung (7) zwischen dem ersten Punkt und dem zweiten Punkt eine räumlich variierende Tiefe aufweist.

2. Kantenemittierender Halbleiterlaser nach Anspruch 1, wobei das Halbleitermaterial der Zwischenschicht (11) mindestens ein Element der III. oder V. Hauptgruppe enthält, das in der zweiten Mantelschicht (1B) nicht enthalten ist.

3. Kantenemittierender Halbleiterlaser nach einem der vorhergehenden Ansprüche, bei dem die zweite Mantelschicht (1B) $Al_xGa_{1-x}As$ mit $0 \leq x \leq 1$ aufweist und die Zwischenschicht (11) In und/oder P enthält.

4. Kantenemittierender Halbleiterlaser nach einem der vorhergehenden Ansprüche, wobei die Zwischenschicht (11) eine Dicke zwischen einschließlich 10 nm und 100 nm aufweist.

5. Kantenemittierender Halbleiterlaser nach einem der vorhergehenden Ansprüche, wobei die zweite Mantelschicht (1B) eine erste Teilschicht (1C), die an den Wellenleiterbereich (4) angrenzt, und eine zweite Teilschicht (1D), die an die erste Teilschicht (1C) angrenzt, enthält, wobei die erste Teilschicht (1C) einen größeren Brechungsindex als die zweite Teilschicht (1D) aufweist.

6. Kantenemittierender Halbleiterlaser nach Anspruch 5, wobei die mindestens eine Zwischenschicht (11, 12) in die erste Teilschicht (1C) der zweiten Mantelschicht (1B) eingebettet ist.

7. Kantenemittierender Halbleiterlaser nach einem der vorhergehenden Ansprüche, wobei die Phasenstruktur (6) zumindest teilweise mit einer Deckschicht (15) versehen ist.

8. Kantenemittierender Halbleiterlaser nach Anspruch 7, wobei die Deckschicht (15) ein Siliziumoxid, ein Siliziumnitrid, ein Siliziumoxinitrid, ein Aluminiumoxid, Zinkselenid, Germanium oder Benzocyclobuten enthält.

9. Kantenemittierender Halbleiterlaser nach einem der vorhergehenden Ansprüche, wobei auf den Halbleiterkörper (10) mindestens ein Kontaktstreifen (8) aufgebracht ist.

10. Kantenemittierender Halbleiterlaser nach Anspruch 9, wobei der Kontaktstreifen (8) eine Breite b zwischen einschließlich 10 $\mu$m und einschließlich 500 $\mu$m aufweist.

11. Kantenemittierender Halbleiterlaser nach Anspruch 9 oder 10, wobei der kantenemittierende Halbleiterlaser mehrere Kontaktstreifen (8) aufweist.

12. Kantenemittierender Halbleiterlaser nach Anspruch 11, bei dem die Kontaktstreifen (8) einen Mittenabstand d und eine Breite b aufweisen, wobei gilt:

$$0{,}01 \leq b/d \leq 0{,}5.$$

13. Kantenemittierender Halbleiterlaser nach einem der vorhergehenden Ansprüche, wobei der Halbleiterlaser im Betrieb Laserstrahlung (17) im infraroten Spektralbereich mit einer Wellenlänge zwischen 780 nm und 1500 nm emittiert.

**Claims**

1. Edge emitting semiconductor laser comprising a semiconductor body (10), which comprises a waveguide region (4) wherein

   - the waveguide region (4) comprises a first waveguide layer (2A), a second waveguide layer (2B) and an active layer (3) arranged between the first waveguide layer (2A) and the second waveguide layer (2B) and serving for generating laser radiation,
   - the waveguide region (4) is arranged between a first cladding layer (1A) and a second cladding layer (1B) disposed downstream of the waveguide region (4) in the growth direction of the semiconductor body (10),
   - a phase structure (6) for the selection of lateral modes of the laser radiation emitted by the active layer (3) is formed in the semiconductor body (10), wherein the phase structure (6) comprises at least one cutout (7) extending from a top side (5) of the semiconductor body (10) into the second cladding layer (1B),
   - at least one first intermediate layer (11) composed of a semiconductor material different than the semiconductor material of the second cladding layer (1B) is embedded into the second cladding layer (1B)
   - the cutout (7) extends from the top side (5) of the semiconductor body (10) at least partly into the first intermediate layer (11), and
   - a second intermediate layer (12) is embedded into the second cladding layer (1B),
   **characterized in that**
   - the cutout (7) extends into the first intermediate layer (11) at at least one first point, and extends into the second intermediate layer (12) at at least one second point, wherein the cutout (7) has a spatially varying depth between the first point and the second point.

2. Edge emitting semiconductor laser according to claim 1,
   wherein the semiconductor material of the intermediate layer (11) contains at least one element of main group III or V which is not contained in the second cladding layer (1B).

3. Edge emitting semiconductor laser according to either of the preceding claims,
   wherein the second cladding layer (1B) comprises $Al_xGa_{1-x}As$ where $0 \leq x \leq 1$ and the intermediate layer (11) contains In and/or P.

4. Edge emitting semiconductor laser according to any of the preceding claims,
   wherein the intermediate layer (11) has a thickness of between 10 nm and 100 nm inclusive.

5. Edge emitting semiconductor laser according to any of the preceding claims,
   wherein the second cladding layer (1B) contains a first partial layer (1C), which adjoins the waveguide region (4), and a second partial layer (1D), which adjoins the first partial layer (1C), wherein the first partial layer (1C) has a greater refractive index than the second partial layer (1D).

6. Edge emitting semiconductor laser according to claim 5,
   wherein the at least one intermediate layer (11, 12) is embedded into the first partial layer (1C) of the second cladding layer (1B).

7. Edge emitting semiconductor laser according to any of the preceding claims,
   wherein the phase structure (6) is at least partly provided with a cover layer (15).

8. Edge emitting semiconductor laser according to claim 7,
   wherein the cover layer (15) contains a silicon oxide, a silicon nitride, a silicon oxynitride, an aluminum oxide, zinc selenide, germanium or benzocyclobutene.

9. Edge emitting semiconductor laser according to any of the preceding claims,
   wherein at least one contact strip (8) is applied to the semiconductor body (10).

10. Edge emitting semiconductor laser according to claim 9,
    wherein the contact strip (8) has a width b of between 10 $\mu$m and 500 $\mu$m inclusive.

11. Edge emitting semiconductor laser according to claim 9 or 10,
    wherein the edge emitting semiconductor laser comprises a plurality of contact strips (8).

12. Edge emitting semiconductor laser according to claim 11,
    wherein the contact strips (8) have a center-to-center distance d and a width b, wherein the following holds true:

$$0.01 \leq b/d \leq 0.5.$$

13. Edge emitting semiconductor laser according to any of the preceding claims,
wherein the semiconductor laser emits laser radiation (17) in the infrared spectral range having a wavelength of between 780 nm and 1500 nm during operation.

## Revendications

1. Laser semi-conducteur émettant par les bords, doté d'un corps semi-conducteur (10) qui présente une partie (4) de guidage d'onde, dans lequel

   - la partie (4) de guidage d'onde présentant une première couche (2A) de guidage d'onde, une deuxième couche (2B) de guidage d'onde et une couche active (3) qui forme le rayonnement laser et qui est disposée entre la première couche (2A) de guidage d'onde et la deuxième couche (2B) de guidage d'onde,
   - la partie (4) de guidage d'onde étant disposée entre une première couche d'enveloppe (1A) et une deuxième couche d'enveloppe (1B) qui suit la partie (4) de guidage d'onde dans la direction de croissance du corps semi-conducteur (10),
   - une structure de phase (6) permettant de sélectionner des modes latéraux du rayonnement laser émis par la couche active (3) étant formée dans le corps semi-conducteur (10), la structure de phase (6) comportant au moins une découpe (7) qui s'étend depuis le côté supérieur (5) du corps semi-conducteur (10) jusque dans la deuxième couche d'enveloppe (1B),
   - au moins une première couche intermédiaire (11) en un matériau semi-conducteur différent du matériau semi-conducteur de la deuxième couche d'enveloppe (1B) étant incorporée dans la deuxième couche d'enveloppe (1B),
   - la découpe (7) s'étendant au moins en partie depuis le côté supérieur (5) du corps semi-conducteur (10) jusque dans la première couche intermédiaire (11) et
   - une deuxième couche intermédiaire (12) étant incorporée dans la deuxième couche d'enveloppe (1B),
   **caractérisé en ce que**
   - la découpe (7) s'étend en au moins un premier point jusque dans la première couche intermédiaire (11) et s'étend en au moins un deuxième point jusque dans la deuxième couche intermédiaire (12), la découpe (7) présentant une profondeur qui varie spatialement entre le premier point et le deuxième point.

2. Laser semi-conducteur émettant par les bords selon la revendication 1, dans lequel le matériau semi-conducteur de la couche intermédiaire (11) contient au moins un élément du groupe principal III. ou du groupe principal V. que la deuxième couche d'enveloppe (1B) ne contient pas.

3. Laser semi-conducteur émettant par les bords selon l'une des revendications précédentes, dans lequel la deuxième couche d'enveloppe (1B) présente du $Al_xGa_{1-x}As$, avec $0 \le x \le 1$ et la couche intermédiaire (11) contient In et/ou P.

4. Laser semi-conducteur émettant par les bords selon l'une des revendications précédentes, dans lequel la ,couche intermédiaire (11) présente une épaisseur comprise entre 10 nm et 100 nm, ces valeurs incluses.

5. Laser semi-conducteur émettant par les bords selon l'une des revendications précédentes, dans lequel la deuxième couche d'enveloppe (1B) contient une première couche partielle (1C) adjacente à la partie (4) de guidage d'onde et une deuxième couche partielle (1D) adjacente à la première couche partielle (1C), la première couche partielle (1C) présentant un indice de réfraction plus grand que la deuxième couche partielle (1D).

6. Laser semi-conducteur émettant par les bords selon la revendication 5, dans lequel la ou les couches intermédiaires (11, 12) sont incorporées dans la première couche partielle (1C) de la deuxième couche d'enveloppe (1B).

7. Laser semi-conducteur émettant par les bords selon l'une des revendications précédentes, dans lequel la structure de phase (6) est dotée au moins en partie d'une couche de recouvrement (15).

8. Laser semi-conducteur émettant par les bords selon la revendication 7, dans lequel la couche de recouvrement (15) contient un oxyde de silicium, un nitrure de silicium, un oxynitrure de silicium, un oxyde d'aluminium, un sélénure de zinc, du germanium ou du benzocyclobutène.

9. Laser semi-conducteur émettant par les bords selon l'une des revendications précédentes, dans lequel au moins un ruban de contact (8) est appliqué sur le corps semi-conducteur (10).

10. Laser semi-conducteur émettant par les bords selon la revendication 9, dans lequel le ruban de contact (8) présente une largeur b comprise entre 10 $\mu$m et 500 $\mu$m, ces valeurs incluses.

11. Laser semi-conducteur émettant par les bords selon les revendications 9 ou 10, dans lequel le laser semi-conducteur à émission par les bords présente plusieurs rubans de contact (8).

**12.** Laser semi-conducteur émettant par les bords selon la revendication 11, dans lequel les rubans de contact (8) présentent une distance d entre les centres et une largeur b, avec

$$0,01 \leq b/d \leq 0,5.$$

**13.** Laser semi-conducteur émettant par les bords selon l'une des revendications précédentes, dans lequel le laser semi-conducteur émet en fonctionnement un rayonnement laser (17) dans la partie spectrale infrarouge, à une longueur d'onde comprise entre 780 nm et 1500 nm.

FIG 1A

FIG 1B

FIG 2A

FIG 2B

FIG 3A

FIG 3B

FIG 4

FIG 5

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- DE 102009051348
- DE 102009056387

- WO 0197349 A1

### In der Beschreibung aufgeführte Nicht-Patentliteratur

- **H.-C. ECKSTEIN et al.** Control of slow axis mode behavior with waveguide phase structures in semiconductor broad-area lasers. *Proceedings of the International Society for Optical Engeneering (SPIE),* 2009, vol. 7320, 7230L1-7

- **S. R. SELMIC et al.** Single Frequency 1550-nm AlGaInAs-InP Tapered High-Power Laser With a Distributed Bragg Reflector. *IEEE Photonics Technology Letters,* 2002, vol. 14 (7), 890-892